# EUROPÄISCHE PATENTSCHRIFT

(11) **EP 1 803 157 B1**
(45) Veröffentlichungstag und Bekanntmachung des Hinweises auf die Patenterteilung: **14.08.2013**
(21) Anmeldenummer: 05792359.1
(22) Anmeldetag: 30.09.2005
(51) Int. Cl.: H01L 27/148, G01J 3/28

(54) **EMCCD-DETEKTOR SOWIE EIN SPEKTROMETER UND MIKROSKOP**
EMCCD DETECTOR AND A SPECTROMETER AND A MICROSCOPE
DETECTEUR EMCCD ET SPECTROMETRE ET MICROSCOPE

(30) Priorität: 20.10.2004 DE 102004051201
(43) Veröffentlichungstag der Anmeldung: 04.07.2007
(73) Patentinhaber: Leica Microsystems CMS GmbH, 35578 Wetzlar (DE)
(72) Erfinder: SEYFRIED, Volker, 69226 Nussloch (DE); SCHREIBER, Frank, 69221 Dossenheim (DE)
(74) Vertreter: Ullrich & Naumann
(86) Internationale Anmeldenummer: PCT/DE2005/001748
(87) Internationale Veröffentlichungsnummer: WO 2006/042497

(56) Entgegenhaltungen:
- EP-A- 0 866 501
- DATABASE INSPEC [Online] THE INSTITUTION OF ELECTRICAL ENGINEERS, STEVENAGE, GB; 2003, COATES C G ET AL: "Ultrasensitivity, speed, and resolution: optimizing low-light microscopy with the back-illuminated electron multiplying CCD" XP002366851 Database accession no. 8025654 -& Proceedings of the SPIE - The International Society for Optical Engineering SPIE-Int. Soc. Opt. Eng USA, Bd. 5139, Nr. 1, 2003, Seiten 56-66, XP002365051 ISSN: 0277-786X
- DATABASE INSPEC [Online] THE INSTITUTION OF ELECTRICAL ENGINEERS, STEVENAGE, GB; 2003, COATES C G ET AL: "Back-illuminated electron multiplying technology: the world's most sensitive CCD for ultralow-light microscopy" XP002366852 Database accession no. 7863540 -& MANIPULATION AND ANALYSIS OF BIOMOLECULES, CELLS, AND TISSUES 28-29 JAN. 2003 SAN JOSE, CA, USA, Bd. 4962, Nr. 1, 2003, Seiten 319-328, XP002365052 Proceedings of the SPIE - The International Society for Optical Engineering SPIE-Int. Soc. Opt. Eng USA ISSN: 0277-786X

## Beschreibung

Die vorliegende Erfindung betrifft einen EMCCD-Detektor, insbesondere zur Detektion von Licht in einem Mikroskop, mit einem photoaktiven Bereich und einem Verstärkerregister. Des Weiteren betrifft die Erfindung ein Spektrometer sowie ein Mikroskop mit einem derartigen EMCCD-Detektor.

EMCCD-Detektoren der eingangs genannten Art sind aus der Praxis bekannt. Dabei handelt es sich um eine spezielle Ausgestaltung eines CCD-Detektors, wobei "EM" für "Electron Multiplying" steht.

Bei herkömmlichen CCD-Detektoren löst jedes Photon bei Auftreffen auf eine photoaktive Schicht des CCD-Detektors ein Elektron aus, das dann in einem von vielen so genannten Potentialtöpfen gefangen ist und dort bis zum Auslesevorgang verbleibt. Beim Auslesevorgang selbst werden die Potentialtöpfe durch Anlegen von Spannungen so beeinflusst, dass die Elektronen in einer so genannten "Eimerkette" von ihrem momentanen Potentialtopf in den jeweils nächstliegenden Potentialtopf weitergegeben werden, bis sie letztendlich zu einer Digitalisierungsstufe gelangen. Allerdings ist das Ausleserauschen hierbei derart hoch - mindestens ca. 20 Elektronen -, dass Einzelelektronen und damit Einzelphotonen nicht mehr vom Rauschen unterschieden werden und einzeln nachgewiesen werden können. Deshalb sind herkömmliche CCD-Detektoren für Standard-Konfokalmikroskope unbrauchbar.

EMCCD-Detektoren, wie z.B. aus der EP 0 866 501 A1 bekannt, weisen wie herkömmliche CCD-Detektoren einen photoaktiven Bereich und darüber hinaus noch ein Verstärkerregister zur Bildung einer Verstärkerstrecke zwischen dem Shift-Register und dem Ausgangsverstärker auf. Die Verstärkung in der Verstärkerstrecke funktioniert ähnlich wie in einer Lawinendiode durch Elektronenvervielfachung. Durch eine hohe Spannung werden Elektronen so stark beschleunigt, dass sie durch lonisationsstöße andere Elektronen freisetzen und dadurch eine Elektronenlawine auslösen können. Mit anderen Worten liegen bei EMCCD-Detektoren spezielle Potentialtöpfe in Form von Verstärkerregistern vor, bei denen der Ladungstransfer in der Eimerkette mit derart viel "Schwung" erfolgt, dass durch Elektronenstoß weitere Elektronen erzeugt werden, die ihrerseits nun auch transportiert und beschleunigt werden und wiederum Elektronen auslösen. Der Verstärkungsfaktor ist allerdings recht gering, so dass sehr viele Verstärkungsstufen - üblicherweise etwa 400 - durchlaufen werden müssen, um eine nennenswerte Verstärkung zu erhalten. Bei ausreichender Verstärkung löst das Primärelektron letztendlich eine solche Elektronenlawine aus, dass die Zahl der Sekundärelektronen das übliche Ausleserauschen übersteigt und somit letztendlich einzelne Photonen detektiert werden können. In dieser Beziehung ähneln die EMCCD-Detektoren den in der Konfokalmikroskopie sonst üblichen Photomultipliern, allerdings haben sie - beispielsweise beim "back-illuminated"-Typ - eine mehr als dreimal so hohe Quanteneffizienz wie die besten Photomultiplier.

Bei den herkömmlichen EMCCD-Detektoren ist jedoch problematisch, dass ihre Ausleserate für eine spektrale Konfokalmikroskopie nicht ausreicht. Daher scheidet ein Einsatz der hochgradig sensitiven EMCCD-Detektoren im Bereich der spektralen Konfokalmikroskopie bislang aus.

Der vorliegenden Erfindung liegt daher die Aufgabe zugrunde, ein Spektrometer und ein Mikroskop der eingangs genannten Art anzugeben, wonach ein Einsatz im Bereich der spektralen Konfokalmikroskopie mit hoher Ausleserate und konstruktiv einfachen Mitteln ermöglicht ist.

Erfindungsgemäß wird die voranstehende Aufgabe durch ein Spektrometer mit den Merkmalen des Patentanspruchs 1 gelöst. Danach ist der EMCCD-Detektor derart ausgestaltet und weitergebildet, dass der photoaktive Bereich in mindestens zwei Detektionsbereiche unterteilt ist und dass einer vorgebbaren Anzahl oder Gruppe oder Anzahl von Gruppen von Detektionsbereichen jeweils mindestens ein separates Verstärkerregister zugeordnet ist.

In erfindungsgemäßer Weise ist zunächst erkannt worden, dass trotz der bislang erreichten und für die spektrale Konfokalmikroskopie zu niedrigen Ausleserate herkömmlicher EMCCD-Detektoren ein Einsatz dieser EMCCD-Detektoren auch im Bereich der spektralen Konfokalmikroskopie bei entsprechender Ausgestaltung des EMCCD-Detektors in vorteilhafter Weise möglich ist. Hierzu ist der EMCCD-Detektor in weiter erfindungsgemäßer Weise derart ausgestaltet, dass der photoaktive Bereich in mindestens zwei Detektionsbereiche unterteilt ist. Diesen mindestens zwei Detektionsbereichen sind nun in geeigneter Weise separate Verstärkerregister zugeordnet, so dass gegebenenfalls eine separate Verstärkung von in den jeweiligen Detektionsbereichen erzeugten Elektronen ermöglicht ist. Hierdurch ist der "Flaschenhals" üblicher EMCCD-Detektoren, bei denen nur ein einziges Verstärkerregister für alle erzeugten Elektronen vorhanden ist, vermieden. Mit anderen Worten sind bei dem erfindungsgemäßen EMCCD-Detektor mehrere derartige "Flaschenhälse" parallel geschaltet. Hierdurch ist ein für die einzelnen Detektionsbereiche jeweils separater Auslesevorgang ermöglicht. Dabei ist einer vorgebbaren Anzahl oder Gruppe oder Anzahl von Gruppen von Detektionsbereichen jeweils mindestens ein separates Verstärkerregister zugeordnet.

Folglich ist mit dem erfindungsgemäßen EMCCD-Detektor ein Detektor angegeben, wonach ein Einsatz im Bereich der spektralen Konfokalmikroskopie mit hoher Ausleserate und konstruktiv einfachen Mitteln ermöglicht ist.

Im Hinblick auf eine besonders hohe Ausleserate könnte jedem Detektionsbereich jeweils mindestens ein separates Verstärkerregister zugeordnet sein. Der Detektor weist dabei folglich mindestens so viele Verstärkerregister wie Detektionsbereiche auf.

Bei einer konstruktiv weniger aufwendigen Ausgestaltung des Detektors könnte zwei Detektionsbereichen mindestens ein separates Verstärkerregister zugeordnet sein. Dabei könnte eine Zusammenfassung von zwei Detektionsbereichen bzw. eine Weiterverarbeitung der ausgelösten Elektronen zweier Detektionsbereiche mittels eines Verstärkerregisters erfolgen. Hierbei ist es weiterhin denkbar, jeweils zwei Detektionsbereichen mindestens ein separates Verstärkerregister zuzuordnen, wobei in diesem Fall sämtliche Detektionsbereiche in Zweiergruppen eingeteilt sein könnten, denen dann jeweils mindestens ein separates Verstärkerregister zugeordnet ist.

Grundsätzlich könnte zur konstruktiven Vereinfachung und bei reduzieren Anforderungen an die Detektionsrate mehreren Detektionsbereichen ein gemeinsames Verstärkerregister zugeordnet sein. Je nach Erfordernis könnte beispielsweise ein dritter Detektionsbereich einem für den ersten oder zweiten Detektionsbereich vorgesehenen Verstärkerregister zugeordnet sein. Grundsätzlich ist bei der Zuordnung der Verstärkerregister zu den Detektionsbereichen auf den jeweiligen Anwendungsfall abzustellen.

Allen Detektionsbereichen ist gemein, dass beim Auftreffen von Licht je ein elektrisches Signal erzeugt wird, wobei die Verstärkerregister die elektrischen Signale verstärken.

Bei einer konstruktiv besonders einfachen Ausgestaltung könnte der Detektor quasi als Punktdetektor ausgebildet sein. Bei einer weiteren Ausgestaltung könnte der Detektor ein eindimensionaler Detektor sein, wobei hier vorzugsweise eine Ausgestaltung als Zeilendetektor besonders günstig ist. Ein derartiger Zeilendetektor könnte insbesondere ein spektral aufgespaltenes Lichtbündel spektral selektiv detektieren, wobei das Lichtbündel hierzu zu einer Fokuslinie auf den Zeilendetektor abgebildet sein könnte. Die Ausgestaltung als Zeilendetektor ist insbesondere bei einem Einsatz des Detektors im Rahmen der spektralen Konfokalmikroskopie besonders vorteilhaft.

Bei einer weiteren Ausgestaltung könnte der Detektor ein zweidimensionaler Detektor sein, wobei die Detektionsbereiche als Fläche angeordnet sein könnten. Eine derartige Fläche könnte eben sein, wobei auch eine gekrümmte Fläche denkbar ist. Bei einer weiteren Ausgestaltung könnte der Detektor ein dreidimensionaler Detektor sein.

Insbesondere bei einer eindimensionalen Ausgestaltung des Detektors und insbesondere bei einer Ausgestaltung als Zeilendetektor könnten die Verstärkerregister im Wesentlichen senkrecht zu einer durch die Detektionsbereiche verlaufenden Geraden angeordnet sein. Dies gewährleistet eine besonders kompakte Ausgestaltung des Detektors.

Im Hinblick auf eine besonders individuelle und universelle Ausgestaltung des Detektors könnten unterschiedliche Verstärkerregister unterschiedliche Verstärkungen oder Verstärkungsfaktoren aufweisen. In weiter vorteilhafter Weise könnte dabei mindestens ein Verstärkerregister und könnten vorzugsweise sämtliche Verstärkerregister jeweils eine einzeln einstellbare Verstärkung oder einen einzeln einstellbaren Verstärkungsfaktor aufweisen. Hierdurch wäre eine individuelle Anpassbarkeit an unterschiedlichste Anwendungen gewährleistet.

Je nach Anforderung könnten alternativ oder zusätzlich hierzu mehrere und vorzugsweise sämtliche Verstärkerregister eine gemeinsam einstellbare Verstärkung oder einen gemeinsam einstellbaren Verstärkungsfaktor aufweisen. Hierdurch wäre eine vereinfachte Einstellbarkeit hinsichtlich der Verstärkung oder hinsichtlich eines Verstärkungsfaktors gewährleistet.

Hinsichtlich einer besonders sicheren Verarbeitung der durch den Detektor erzeugten elektrischen Signale könnte eine vorzugsweise parallel arbeitende Verarbeitungselektronik - vorzugsweise FPGA - vorgesehen sein. In weiter individueller und vorteilhafter Weise könnte die Verarbeitungselektronik zu einer intelligenten Auswertung ausgebildet sein, wobei beispielsweise bei einer Mikroskopieranwendung eine direkte Zuordnung zwischen Detektionssignalen und beispielsweise einem in der Probe vorhandenen Farbstoff erfolgen könnte.

Hinsichtlich einer besonders hohen Sensitivität und Quanteneffizienz könnte der Detektor zum "back-illuminated" oder von hinten beleuchteten Betrieb ausgebildet sein. Dabei könnte vermieden werden, dass die Beleuchtung durch verarbeitende und/oder versorgende elektronische Strukturen des Detektors noch vor ihrer Detektion hindurchtreten müsste. Letztendlich ist hierdurch kein Verlust an Quantenausbeute zu erwarten.

Im Rahmen einer alternativen Ausgestaltung könnte der Detektor zum "front-illuminated" oder von vorne beleuchteten Betrieb ausgebildet sein. Hinsichtlich der Beleuchtungsseite ist auf den jeweiligen Anwendungsfall abzustellen.

Bei einer besonders komfortablen Ausgestaltung des Detektors könnten die erzeugten Detektionssignale mehrerer Detektionsbereiche addierbar sein. Je nach gewünschtem Messergebnis könnte eine derartige Addition vorgesehen sein oder auch nicht.

In weiter vorteilhafter Weise könnten die Detektionsbereiche unterschiedliche Größen aufweisen. Eine derartige Ausgestaltung ist insbesondere bei Vorliegen eines spektral aufgespaltenen Lichtbündels günstig, wenn das jeweilige spektral aufspaltende Element eine nichtlineare Aufspaltung erzeugt. Mit nichtlinearer Aufspaltung ist hier gemeint, dass die Winkelablenkung durch ein dispersives Element - beispielsweise ein Prisma - nicht proportional zur Wellenlänge ist. Beispielsweise sind die Linien im blauen Spektralbereich räumlich dichter als im roten Spektralbereich. Bei unterschiedlich groß ausgestalteten Detektionsbereichen könnte bei geeigneter Wahl der Größe der Detektionsbereiche eine Linearisierung erreicht werden.

Je nach Anwendungsfall, beispielsweise bei einem linear aufspaltenden dispersiven Element, könnten die Detektionsbereiche im Wesentlichen gleich groß sein.

Zur Realisierung eines besonders einfach handhabbaren Detektors könnte der Detektor als Chip oder Modul ausgebildet sein oder in einen Chip oder Modul integriert sein. Hierdurch könnten mechanisch bewegliche Teile eines EMCCD-Detektors vermieden werden, so dass ein Service- und Wartungsbedarf minimiert wäre. Entsprechend ist die Justage und Kalibrierung des derart ausgebildeten EMCCD-Detektors entsprechend einfach.

Die voranstehende Aufgabe wird weiterhin durch ein Spektrometer mit einem EMCCD-Detektor nach einem der Ansprüche 1 bis 22 gelöst. Ein derartiges Spektrometer könnte in vorteilhafter Weise mit einem als Zeilendetektor ausgebildeten EMCCD-Detektor ausgerüstet sein, wobei weiterhin ein dispersives optisches Element vorhanden ist und wobei ein von dem Element räumlich spektral aufgespaltenes Lichtbündel zu einer Fokuslinie auf den Zeilendetektor abgebildet ist. Ein derartiges Spektrometer könnte insbesondere im Bereich der spektralen Konfokalmikroskopie eingesetzt werden.

Die voranstehende Aufgabe ist weiterhin durch ein Mikroskop, insbesondere Raster-, Scan- oder konfokales Scanmikroskop, mit einem EMCCD-Detektor nach einem der Ansprüche 1 bis 22 gelöst. Ein derartiges Mikroskop könnte in vorteilhafter Weise derart weitergebildet sein, dass der EMCCD-Detektor Bestandteil eines Spektrometers und/oder Multibanddetektors ist.

Hinsichtlich der Diskussion der Vorteile besonderer Ausgestaltungen des erfindungsgemäßen EMCCD-Detektors im Zusammenhang mit dem beanspruchten Spektrometer oder dem beanspruchten Mikroskop wird zur Vermeidung von Wiederholung auf die bereits erfolgte Beschreibung dieser Vorteile im vorherigen Text verwiesen.

Der erfindungsgemäße EMCCD-Detektor könnte in vielen Anwendungen als Ersatz für Photomultiplier dienen. Die Quanteneffizienz könnte bei entsprechender Ausgestaltung dreimal so hoch wie bei Photomultipliern liegen.

Es gibt nun verschiedene Möglichkeiten, die Lehre der vorliegenden Erfindung in vorteilhafter Weise auszugestalten und weiterzubilden. Dazu ist einerseits auf die nachgeordneten Ansprüche, andererseits auf die nachfolgende Erläuterung bevorzugter Ausführungsbeispiele der erfindungsgemäßen Lehre anhand der Zeichnung zu verweisen. In Verbindung mit der Erläuterung der bevorzugten Ausführungsbeispiele der erfindungsgemäßen Lehre anhand der Zeichnung werden auch im Allgemeinen bevorzugte Ausgestaltungen und Weiterbildungen der Lehre erläutert. In der Zeichnung zeigen
- Fig. 1: in einer schematischen Darstellung ein Scanmikroskop mit einem Ausführungsbeispiel eines erfindungsgemäßen EMCCD-Detektors,
- Fig. 2: in einer schematischen Seitenansicht das Ausführungsbeispiel eines EMCCD-Detektors aus Fig. 1, wobei es sich hier um einen Zeilendetektor handelt,
- Fig. 3: in einer schematischen Seitenansicht ein weiteres Ausführungsbeispiel eines erfindungsgemäßen EMCCD-Detektors, wobei es sich hier ebenfalls um einen Zeilendetektor handelt, und
- Fig. 4: in einer schematischen Draufsicht ein weiteres Ausführungsbeispiel eines erfindungsgemäßen EMCCD-Detektors, wobei hier eine flächige Anordnung der Detektorbereiche realisiert ist.

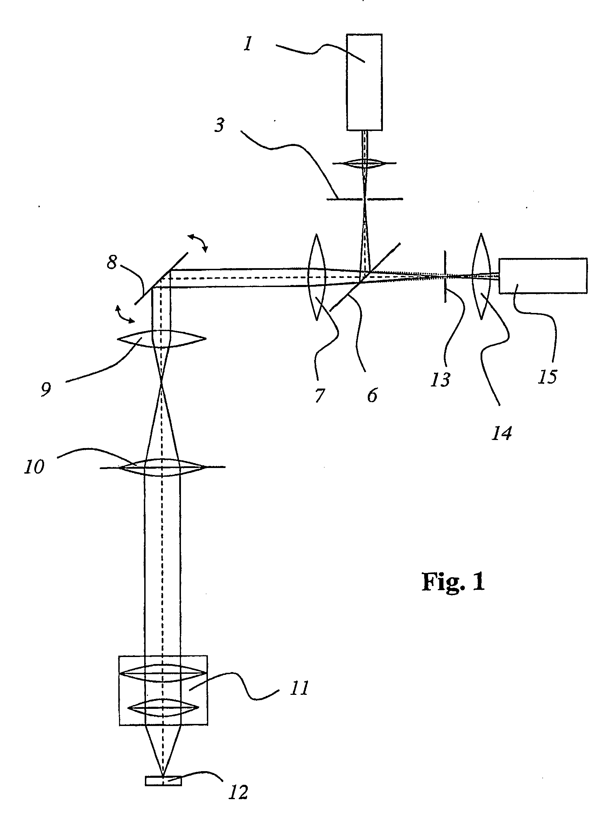

Fig. 1 zeigt in einer schematischen Draufsicht ein Scanmikroskop mit einem Laser 1 zur Erzeugung eines Beleuchtungslichtstrahls. Der Beleuchtungslichtstrahl wird über ein Pinhole 3, einen Strahlteiler 6, ein optisches Element 7, einen Scanspiegel 8, ein optisches Element 9, ein optisches Element 10 und eine Optik 11 zu einer Probe 12 geführt. Von der Probe 12 wird der Beleuchtungslichtstrahl zurück zum Scanspiegel 8 und zum Strahlteiler 6 reflektiert und dann über ein Pinhole 13 zu einer Optik 14 und einem EMCCD-Detektor 15 zur Detektion von Licht geführt.

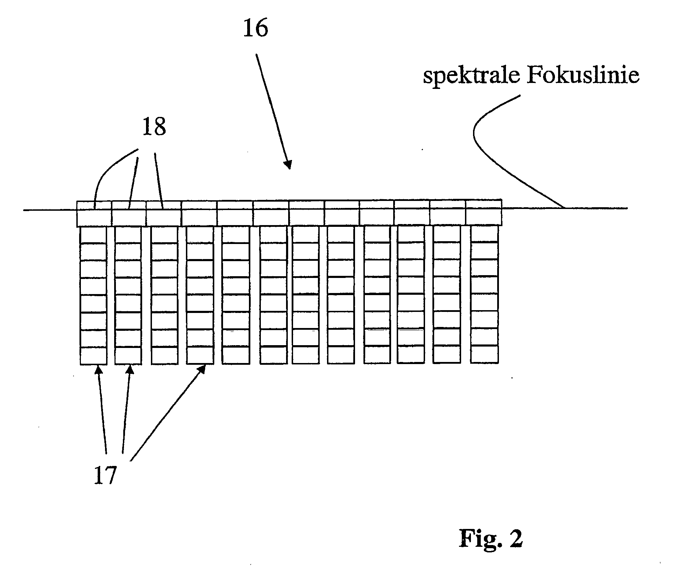

Fig. 2 zeigt in einer schematischen Seitenansicht ein Ausführungsbeispiel eines erfindungsgemäßen EMCCD-Detektors 15, der als Zeilendetektor ausgebildet ist. Der Detektor 15 weist einen photoaktiven Bereich 16 und mehrere Verstärkerregister 17 auf. Dabei ist der photoaktive Bereich 16 in mehrere Detektionsbereiche 18 unterteilt, wobei jedem Detektionsbereich 18 ein separates Verstärkerregister 17 zugeordnet ist. Mit einer derartigen Ausgestaltung lässt sich eine besonders hohe Ausleserate realisieren. In Fig. 2 ist eine spektrale Fokuslinie dargestellt, entlang welcher eine spektrale Auffächerung des Detektionslichtstrahls mittels der in Fig. 1 gezeigten Optik 14 erfolgt ist. Dabei sind die Verstärkerregister 17 im Wesentlichen senkrecht zu dieser durch die Detektionsbereiche 18 verlaufenden Geraden angeordnet.

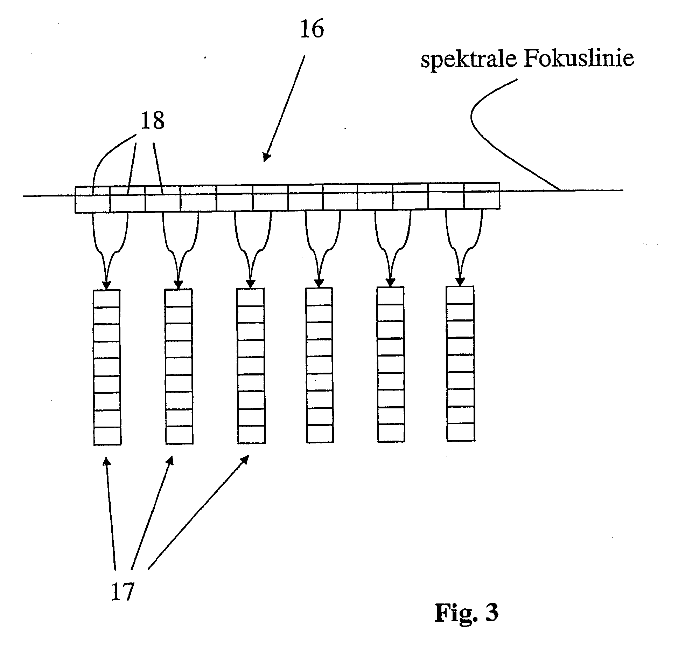

Fig. 3 zeigt in einer schematischen Seitenansicht ein weiteres Ausführungsbeispiel eines erfindungsgemäßen EMCCD-Detektors 15. Der Detektor 15 weist ebenfalls eine Unterteilung des photoaktiven Bereichs 16 in mehrere Detektionsbereiche 18 auf. Bei dem hier gezeigten Ausführungsbeispiel ist immer zwei Detektionsbereichen 18 ein Verstärkerregister 17 zugeordnet. Auch hier verläuft die spektrale Fokuslinie im Wesentlichen senkrecht zu den Verstärkerregistern 17.

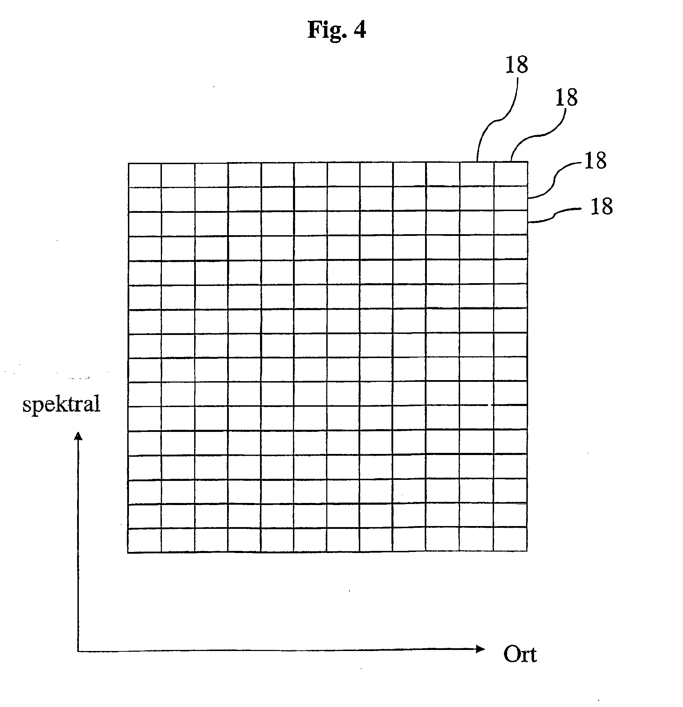

Fig. 4 zeigt in einer schematischen Draufsicht ein weiteres Ausführungsbeispiel eines erfindungsgemäßen EMCCD-Detektors 15. Dabei ist der photoaktive Bereich 16 in mehrere Detektionsbereiche 18 unterteilt, die flächig in einem Koordinatensystem angeordnet sind. Diese Anordnung bietet sich für einen konfokalen Zeilenscaner an. Das Koordinatensystem weist eine Aufteilung nach Ort und zu detektierendem Spektralbereich auf.

Hinsichtlich weiterer vorteilhafter Ausgestaltungen des erfindungsgemäßen EMCCD-Detektors wird zur Vermeidung von Wiederholungen auf den allgemeinen Teil der Beschreibung sowie auf die beigefügten Patentansprüche verwiesen.

Schließlich sei ausdrücklich darauf hingewiesen, dass die voranstehend beschriebenen Ausführungsbeispiele lediglich zur Erörterung der beanspruchten Lehre dienen, diese jedoch nicht auf die Ausführungsbeispiele einschränken.

## Patentansprüche

1. Spektrometer mit einem als Zeilendetektor ausgebildeten EMCCD-Detektor (15), insbesondere zur Detektion von Licht in einem Mikroskop, mit einem photoaktiven Bereich (16), der in mindestens einen ersten und einen zweiten Detektionsbereich (18) unterteilt ist, wobei einer vorgebbaren Anzahl oder Gruppe oder Anzahl von Gruppen von Detektionsbereichen (18) jeweils mindestens ein separates Verstärkerregister (17) zugeordnet ist, wobei dem ersten Detektionsbereich (18) ein erstes Verstärkerregister (17) und dem zweiten Detektionsbereich (18) ein zweites Verstärkerregister (17) zugeordnet ist,
wobei die Detektionsbereiche (18) unterschiedliche Größen aufweisen, wobei das Spektrometer ein dispersives optisches Element aufweist und wobei ein von dem dispersiven optischen Element räumlich spektral aufgespaltenes Lichtbündel zu einer Fokuslinie auf den Zeilendetektor abgebildet ist.

2. Spektrometer nach Anspruch 1, **dadurch gekennzeichnet, dass** jedem Detektionsbereich (18) jeweils mindestens ein separates Verstärkerregister (17) zugeordnet ist oder
dass zwei Detektionsbereichen (18) mindestens ein separates Verstärkerregister (17) zugeordnet ist.

3. Spektrometer nach Anspruch 1 oder 2, **dadurch gekennzeichnet, dass** jeweils zwei Detektionsbereichen (18) mindestens ein separates Verstärkerregister (17) zugeordnet ist und/oder
dass mehreren Detektionsbereichen (18) ein gemeinsames Verstärkerregister (17) zugeordnet ist.

4. Spektrometer nach Anspruch 1, **dadurch gekennzeichnet, dass** ein dritter Detektionsbereich (18) einem für den ersten oder zweiten Detektionsbereich (18) vorgesehenen Verstärkerregister (17) zugeordnet ist.

5. Spektrometer nach einem der Ansprüche 1 bis 4, **dadurch gekennzeichnet, dass** die Verstärkerregister (17) im Wesentlichen senkrecht zu einer durch die Detektionsbereiche (18) verlaufenden Geraden angeordnet sind und/oder dass unterschiedliche Verstärkerregister (17) unterschiedliche Verstärkungen oder Verstärkungsfaktoren aufweisen.

6. Spektrometer nach einem der Ansprüche 1 bis 5, **dadurch gekennzeichnet, dass** mindestens ein Verstärkerregister (17) und vorzugsweise sämtliche Verstärkerregister (17) jeweils eine einzeln einstellbare Verstärkung oder einen einzeln einstellbaren Verstärkungsfaktor aufweist oder aufweisen und/oder dass mehrere und vorzugsweise sämtliche Verstärkerregister (17) eine gemeinsam einstellbare Verstärkung oder einen gemeinsam einstellbaren Verstärkungsfaktor aufweisen.

7. Spektrometer nach einem der Ansprüche 1 bis 6, **dadurch gekennzeichnet, dass** eine vorzugsweise parallel arbeitende Verarbeitungselektronik - vorzugsweise FPGA - zur Verarbeitung der erzeugten elektrischen Detektionssignale vorgesehen ist, wobei vorzugsweise
die Verarbeitungselektronik zu einer intelligenten Auswertung ausgebildet ist.

8. Spektrometer nach einem der Ansprüche 1 bis 7, **dadurch gekennzeichnet, dass** der Detektor (15) zum "back-illuminated" oder von hinten beleuchteten Betrieb ausgebildet ist und/oder
dass der Detektor (15) zum "front-illuminated" oder von vorne beleuchteten Betrieb ausgebildet ist und/oder
dass die erzeugten Detektionssignale mehrerer Detektionsbereiche (18) addierbar sind.

9. Spektrometer nach einem der Ansprüche 1 bis 8, **dadurch gekennzeichnet, dass** der Detektor (15) als Chip oder Modul ausgebildet oder in einen Chip oder Modul integriert ist.

## Claims

1. Spectrometer having an EMCCD detector (15) in the form of a line detector, in particular for detecting light in a microscope, having a photoactive region (16) which is subdivided into at least a first and a second detection region (18), at least one separate amplifier register (17) being associated with a predeterminable number or group or number of groups of detection regions (18), respectively, a first amplifier register (17) being associated with the first detection region (18) and a second amplifier register (17) being associated with the second detection region (18), wherein the detection regions (18) have different magnitudes, the spectrometer having a dispersive optical element and a light beam which is split in a spatially spectral manner by the dispersive optical element being imaged to form a focal line on the line detector.

2. Spectrometer according to claim 1, **characterised in that** at least one separate amplifier register (17) is associated with each detection region (18) or
**in that** at least one separate amplifier register (17) is associated with two detection regions (18).

3. Spectrometer according to claim 1 or claim 2, **characterised in that** at least one separate amplifier register (17) is associated with two detection regions (18) and/or
**in that** a common amplifier register (17) is associated with a plurality of detection regions (18).

4. Spectrometer according to claim 1, **characterised in that** a third detection region (18) is associated with an amplifier register (17) provided for the first or second detection region (18).

5. Spectrometer according to any one of claims 1 to 4, **characterised in that** the amplifier registers (17) are arranged substantially perpendicularly relative to a straight line which extends through the detection regions (18) and/or in that different amplifier registers (17) have different amplifications or amplification factors.

6. Spectrometer according to any one of claims 1 to 5, **characterised in that** at least one amplifier register (17) and preferably all the amplifier registers (17) has/have an individually adjustable amplification or an individually adjustable amplification factor and/or
**in that** a plurality of and preferably all the amplifier registers (17) have a commonly adjustable amplification or a commonly adjustable amplification factor.

7. Spectrometer according to any one of claims 1 to 6, **characterised in that** an electronic processing unit - preferably FPGA - which preferably operates in a parallel manner is provided to process the electrical detection signals produced, with
the electronic processing unit preferably being constructed for intelligent evaluation.

8. Spectrometer according to any one of claims 1 to 7, **characterised in that** the detector (15) is constructed for "back-illuminated" operation and/or
**in that** the detector (15) is constructed for "front-illuminated" operation and/or
**in that** the produced detection signals of a plurality of detection regions (18) can be added together.

9. Spectrometer according to any one of claims 1 to 8, **characterised in that** the detector (15) is constructed as a chip or module or is integrated in a chip or module.

## Revendications

1. Spectromètre avec un détecteur EMCCD (15), en particulier pour la détection de lumière dans un microscope, comportant une zone (16) photoactive qui est subdivisée en au moins une première et une deuxième zone de détection (18), un registre amplificateur (17) étant associé à un nombre ou un groupe ou un nombre de groupes prédéfinissable de zones de détection (18), un premier registre amplificateur (17) étant associé à la première zone de détection (18) et un deuxième registre amplificateur (17) étant associé à la deuxième zone de détection (18),
lesdites zones de détection (18) ayant des tailles différentes, le spectromètre comportant un élément optique dispersif, et un faisceau de lumière décomposé en spectres dans l'espace par l'élément optique dispersif étant reproduit par rapport à une ligne focale sur le détecteur de lignes.

2. Spectromètre selon la revendication 1, **caractérisé en ce qu'**au moins un registre amplificateur (17) séparé est associé à chaque zone de détection (18) ou **en ce qu'**au moins un registre amplificateur (17) séparé est associé à deux zones de détection (18).

3. Spectromètre selon la revendication 1 ou 2, **caractérisé en ce qu'**au moins un registre amplificateur (17) séparé est associé à respectivement deux zones de détection (18) et/ou **en ce qu'**un registre amplificateur (17) commun est associé à plusieurs zones de détection (18).

4. Spectromètre selon la revendication 1, **caractérisé en ce qu'**une troisième zone de détection (18) est associée à un registre amplificateur (17) prévu pour la première ou la deuxième zone de détection (18).

5. Spectromètre selon l'une quelconque des revendications 1 à 4, **caractérisé en ce que** les registres amplificateurs (17) sont disposés sensiblement perpendiculairement à une droite passant par les zones de détection (18) et/ou **en ce que** des registres amplificateurs (17) différents comportent des amplifications ou facteurs d'amplification différents.

6. Spectromètre selon l'une quelconque des revendications 1 à 5, **caractérisé en ce qu'**au moins un registre amplificateur (17) et, de préférence, tous les registres amplificateurs (17) comporte ou comportent chacun une amplification réglable individuellement ou un facteur d'amplification réglable individuellement, et/ou **en ce que** plusieurs et, de préférence, tous les registres amplificateurs (17) comportent une amplification réglable conjointement ou un facteur d'amplification réglable conjointement.

7. Spectromètre selon l'une quelconque des revendications 1 à 6, **caractérisé en ce qu'**une électronique de traitement - de préférence, un FPGA - fonctionnant de préférence en parallèle, est prévue pour le traitement des signaux de détection électriques générés, ladite électronique de traitement étant réalisée de préférence pour une analyse intelligente.

8. Spectromètre selon l'une quelconque des revendications 1 à 7, **caractérisé en ce que** le détecteur (15) est configuré pour un fonctionnement « back-illuminated » ou rétroéclairé, et/ou **en ce que** le détecteur (15) est configuré pour un fonctionnement « front-illuminated » ou éclairé de face, et/ou **en ce que** les signaux de détection générés de plusieurs zones de détection (18) peuvent être additionnés.

9. Spectromètre selon l'une quelconque des revendications 1 à 8, **caractérisé en ce que** le détecteur (15) est configuré sous forme de puce ou module ou est intégré dans une puce ou un module.
